# EUROPÄISCHE PATENTANMELDUNG

(11) **EP 3 001 497 A1**
(43) Veröffentlichungstag der Anmeldung: **30.03.2016**
(21) Anmeldenummer: 14185881.1
(22) Anmeldetag: 23.09.2014
(51) Int. Cl.: H01M 10/42, G01R 31/36, H01M 10/44, H01M 10/48, H02J 7/00

(54) **Intelligentes Ladeende**

(71) Anmelder: HILTI Aktiengesellschaft, 9494 Schaan (LI)
(72) Erfinder: Mayer, Stefan, 81377 München (DE)
(74) Vertreter: Hilti Aktiengesellschaft Corporate Intellectual Property

(57) **Zusammenfassung**

Verfahren zum Steuern eines Akkumulators, wobei der Akkumulator eine Steuerungseinrichtung enthält und beispielsweise zur Versorgung einer Werkzeugmaschine mit elektrischer Energie verwendbar ist. Das Verfahren beinhaltet die Schritte: Ermitteln eines Differenzwertes zwischen einem ersten Ladezustand des Akkumulators und einem zweiten Ladezustand des Akkumulators, wobei der erste Ladezustand einem Ladezustand des Akkumulators nach Beendigung eines Ladevorgangs entspricht und der zweite Ladezustand einen geringeren Ladezustandswert als der erste Ladezustand aufweist; Festlegen eines dritten Ladezustands, der dem Differenzwert entspricht, wobei der dritte Ladezustand einem Ladezustandswert entspricht, der geringer als ein maximaler Ladezustandswert des Akkumulators ist; und Laden des Akkumulators bis zum Erreichen des dritten Ladezustands.

Akkumulator zur Durchführung des Verfahrens.

## Beschreibung

### "Intelligentes Ladeende"

Die vorliegende Erfindung bezieht sich auf ein Verfahren zum Steuern eines Akkumulators, wobei der Akkumulator eine Steuerungseinrichtung enthält und beispielsweise zur Versorgung einer Werkzeugmaschine mit elektrischer Energie verwendbar ist. darüber hinaus bezieht sich die Erfindung auf ein Akkumulator zur Durchführung dieses Verfahrens.

Akkumulatoren, insbesondere Lithium-Ionen-Akkumulator, erfahren durch eine Anzahl an Umwelteinflüssen sowie durch nicht fachgerechte Handhabung eine beschleunigte Alterung, die zu einem reduzierten Leistungsvermögen und einer insgesamt verkürzten Lebenszeit des Akkumulators führen kann. Neben den Umwelteinflüssen, wie beispielsweise zu hohe oder zu tiefe Umgebungstemperaturen, stellt speziell das oftmals unsachgemäße Aufladen eines Akkumulators ein Problem für das Leistungsvermögen (z.B. Abgabe der maximale Nennkapazität) und die Lebensdauer des Akkumulators dar.

Es ist daher Aufgabe der vorliegenden Erfindung das vorstehend beschriebene technische Problem zu lösen und insbesondere das Leistungsvermögen eines Akkumulators zu optimieren sowie die Lebensdauer eines Akkumulators zu erhöhen. Hierzu wird ein Verfahren zum Steuern eines Akkumulators bereitgestellt. Durch das Verfahren kann das Leistungsvermögen und die Lebensdauer des Akkumulators optimiert bzw. erhöht werden.

Diese Aufgabe wird erfindungsgemäss durch den Gegenstand des unabhängigen Anspruchs 1 und 6 gelöst.

Hierzu wird ein Verfahren bereitgestellt zum Steuern eines Akkumulators, wobei der Akkumulator eine Steuerungseinrichtung enthält und beispielsweise zur Versorgung einer Werkzeugmaschine mit elektrischer Energie verwendbar ist.

Das Verfahren kennzeichnet sich erfindungsgemäß durch die Schritte:
- Ermitteln eines Differenzwertes zwischen einem ersten Ladezustand des Akkumulators und einem zweiten Ladezustand des Akkumulators, wobei der erste Ladezustand einem Ladezustand des Akkumulators nach Beendigung eines Ladevorgangs entspricht und der zweite Ladezustand einen geringeren Ladezustandswert als der erste Ladezustand aufweist;
- Festlegen eines dritten Ladezustands, der dem Differenzwert entspricht, wobei der dritte Ladezustand einem Ladezustandswert entspricht, der geringer als ein maximaler Ladezustandswert des Akkumulators ist; und
- Laden des Akkumulators bis zum Erreichen des dritten Ladezustands.

Durch das Festlegen sowie das Laden des Akkumulators bis zum Erreichen des dritten Ladezustands, der geringer ist als ein maximaler Ladezustandswert des Akkumulators, wird erreicht, dass der Akkumulator nicht mehr bis zu einem maximalen Ladezustand aufgeladen wird. Hierdurch wird einer vorzeitigen bzw. beschleunigten Alterung des Akkumulators entgegengewirkt und das Leistungsvermögen sowie die Lebensdauer des Akkumulators optimiert.

Gemäß einer weiteren vorteilhaften Ausführungsform der vorliegenden Erfindung kann vorgesehen sein, dass das Festlegen des dritten Ladezustands nach einer vorbestimmten Anzahl an Ladevorgängen des Akkumulators erfolgt, wobei der Ladezustandswert des dritten Ladezustands einem durchschnittlichen Differenzwert entspricht. Die vorbestimmte Anzahl kann dabei wenigstens drei Ladevorgängen des Akkumulators entsprechen. Es ist jedoch auch möglich, dass die vorbestimmte Anzahl weniger als oder genau drei Ladevorgängen des Akkumulators entspricht. Hierdurch kann der dritte Ladezustand auf einen Ladezustandswert festgelegt werden, der einem tatsächlich verwendeten bzw. maximal notwendigen Ladezustand für den Akkumulator entspricht.

Um eine flexible Festlegung auf den dritten Ladezustand zu gewährleisten, kann es möglich sein, dass das Festlegen des dritten Ladezustands auf einen vorbestimmten ersten Schwellwert erfolgt, wenn der zweite Ladezustand einen vorbestimmten zweiten Schwellwert unterschreitet.

Entsprechend einer weiteren vorteilhaften Ausführungsform kann es möglich sein, dass das Festlegen des dritten Ladezustands mittels einer an dem Akkumulator positionierten Eingabevorrichtung erfolgt. Hierdurch ist es für einen Anwender des Akkumulators bzw. einer Werkzeugmaschine verbunden mit dem Akkumulator möglich, den dritten Ladezustand frei zu wählen und somit das Leistungsvermögen des Akkumulators beliebig zu erhöhen oder abzusenken.

Gemäß einer weiteren vorteilhaften Ausführungsform der vorliegenden Erfindung kann vorgesehen sein, dass der erste, zweite und dritte Ladezustand einer Kapazität, einer Ladespannung oder einem Ladestrom entspricht.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:
- Fig. 1: eine schematische Darstellung einer Werkzeugmaschine zusammen mit einem erfindungsgemäßen Akkumulator zum Betreiben des erfindungsgemäßen Verfahrens zum Steuern des Akkumulators;
- Fig. 2: eine schematische Darstellung des Akkumulators in Verbindung mit einem Ladegerät;
- Fig. 3: eine Ablaufdiagramm des erfindungsgemäßen Verfahrens zum Steuern eines Akkumulators gemäß einer ersten Ausführungsform;
- Fig. 4: eine Ablaufdiagramm des erfindungsgemäßen Verfahrens zum Steuern eines Akkumulators gemäß einer zweiten Ausführungsform;
- Fig. 5: eine Ablaufdiagramm des erfindungsgemäßen Verfahrens zum Steuern eines Akkumulators gemäß einer dritten Ausführungsform ; und
- Fig. 6: eine Ablaufdiagramm des erfindungsgemäßen Verfahrens zum Steuern eines Akkumulators gemäß einer vierten Ausführungsform.

### Ausführungsbeispiel:

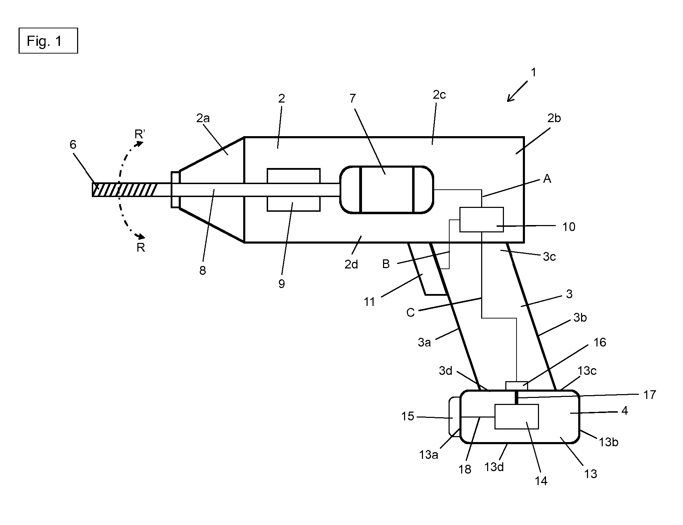

Fig. 1 zeigt eine Werkzeugmaschine 1 in Form einer Bohrmaschine. Die als Bohrmaschine ausgestaltete Werkzeugmaschine 1 enthält im Wesentlichen ein Gehäuse 2, ein Griffstück 3 sowie einen Akkumulator 4.

Das Gehäuse 2 enthält ein vorderes Ende 2a, ein hinteres Ende 2b, ein oberes Ende 2c und ein unteres Ende 2d. An dem vorderen Ende 2a ist eine Werkzeugaufnahme 5 positioniert, die ein Werkzeug 6 hält. Das Werkzeug 6 ist als Bohrer gestaltet. In dem Gehäuse 2 sind ein Elektromotor 7, eine Abtriebswelle 8, ein Getriebe 9 und eine Steuerungseinrichtung 10 positioniert. Mit Hilfe des Elektromotors 7 wird die Abtriebswelle 8 über das Getriebe 9 angetrieben. Die Abtriebswelle 8 ist wiederum fest mit dem als Bohrer ausgestalteten Werkzeug 6 verbunden, sodass die Drehbewegung bzw. das Drehmoment von der Abtriebswelle 8 auf den Bohrer 6 übertragen wird. Der Bohrer 6 kann somit entweder in Richtung R oder in Richtung R' gedreht werden.

Die Steuerungseinrichtung 10 ist mit dem Elektromotor 7 zum Steuern der Drehzahl des Elektromotors 7 sowie zum Steuern des in dem Elektromotor 7 erzeugten Drehmoments ausgestaltet. Hierzu ist die Steuerungseinrichtung 10 über eine Leitung A mit dem Elektromotor 7 verbunden.

Das Griffstück 3 enthält ein vorderes Ende 3a, ein hinteres Ende 3b, ein oberes Ende 3c und ein unteres Ende 3d. An dem unteren Ende 3d sowie in Nähe des hinteren Endes 2b des Gehäuses 2 ist das obere Ende 3c des Griffstücks 3 befestigt. An dem vorderen Ende 3a des Griffstücks 3 ist ein Schalter 11 vorgesehen. Der Schalter 11 ist in Form eines Potentiometers ausgestaltet und über eine Verbindungsleitung B mit der Steuerungseinrichtung 10 verbunden. Mit dem Schalter 11 kann die als Bohrmaschine ausgestaltete Werkzeugmaschine 1 ein- und ausgeschaltet werden. Darüber hinaus können mit dem Schalter 11 die Drehzahl des Elektromotors 7 sowie das in dem Elektromotor 7 erzeugte Drehmoment stufenlos variiert werden.

Der Akkumulator 4 enthält im Wesentlichen ein Akkugehäuse 13, eine Akku-Steuerungseinrichtung 14, eine Eingabeeinrichtung 15 sowie eine Anzahl an einzelnen wiederaufladbaren Speicherelementen für elektrische Energie. Die Speicherelemente können als Sekundärelemente oder Sekundärzellen bezeichnet werden. Die Speicherelemente sind in den Figuren nicht dargestellt.

Das Akkugehäuse 13 enthält dabei ein vorderes Ende 13a, ein hinteres Ende 13b, ein oberes Ende 13c und ein unteres Ende 13d. An dem oberen Ende 13c des Akkugehäuse 13 ist eine Schnittstelle 16 positioniert, mit der der Akkumulator 4 mit dem unteren Ende 3d des Griffstücks 3 und somit mit der Bohrmaschine 1 verbindbar ist. Die Schnittstelle 16 enthält dabei mehrere Kontakte, über die Informationen und elektrische Energie transportiert werden können. Die einzelnen Kontakte sind in den Figuren nicht gezeigt. Der Akkumulator 4 und insbesondere die Schnittstelle 16 sind über eine Leitung C mit der Steuerungseinrichtung 10 verbunden. Damit steht die Steuerungseinrichtung 10 sowie die Akku-Steuerungseinrichtung 14 miteinander in Verbindung.

Die Akku-Steuerungseinrichtung 14 ist in dem Akkugehäuse 13 positioniert und über eine Leitung 17 mit der Schnittstelle 16 verbunden. Die Akku-Steuerungseinrichtung 14 enthält des Weiteren eine nicht gezeigte Speichereinheit.

Die Eingabeeinrichtung 15 ist an dem vorderen Ende 13a des Akkugehäuse 13 positioniert und mittels einer Leitung 18 mit der Akku-Steuerungseinrichtung 14 verbunden. Die Eingabeeinrichtung 15 enthält eine Anzahl an Betätigungselementen sowie eine Anzeigeneinheit. Die Betätigungselemente sind in Form von Schaltern ausgestaltet. Die Anzeigeneinheit ist als Display gestaltet. Weder die Betätigungselemente noch die Anzeigeneinheit sind in den Figuren dargestellt. Wie nachfolgend im Detail beschrieben, dient die Eingabeeinrichtung 15 dazu, Daten und Informationen (wie z.B. Schwellwerte für eine Ladungsgrenze) in den Akkumulator 4 einzugeben.

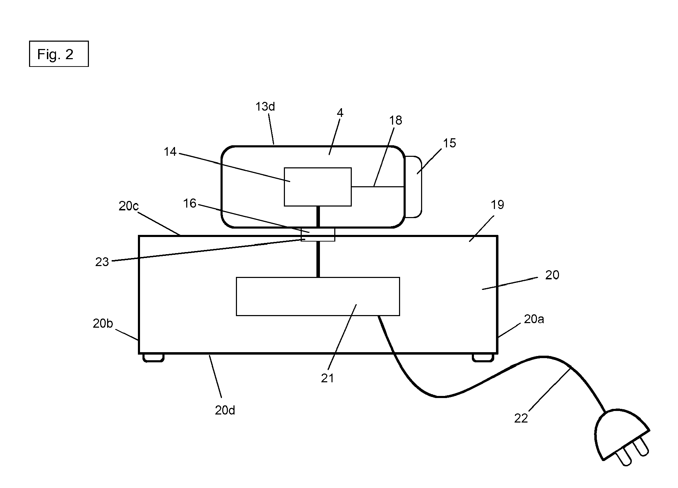

Fig. 2 zeigt den Akkumulator 4 in Verbindung mit einem Ladegerät 19. Das Ladegerät 19 enthält im Wesentlichen ein Gehäuse 20, eine Steuerungseinrichtung 21 und ein Stromkabel 22. Das Stromkabel 22 dient dazu, das Ladegerät 19 mit einer (nicht gezeigten) Netzstromquelle (Steckdose) zu verbinden. Das Gehäuse 20 enthält ein vorderes Ende 20a, ein hinteres Ende 20b, ein oberes Ende 20c und ein unteres Ende 20d. An dem oberen Ende 20c des Gehäuses 20 des Ladegeräts 19 ist eine Schnittstelle 23 angeordnet. Die Schnittstelle 23 enthält mehrere Kontakte, über die Informationen und elektrische Energie transportiert werden können. Die Schnittstelle 23 des Ladegeräts 19 ist dabei so ausgestaltet, dass diese mit der Schnittstelle 16 des Akkumulators 4 verbunden werden kann. Mit Hilfe der Verbindung der beiden Schnittstellen 23, 16 können Informationen und elektrische Energie zwischen dem Akkumulator 4 und dem Ladegeräts 19 ausgetauscht werden. Insbesondere kann elektrische Energie von dem Ladegerät 19 zu dem Akkumulator 4 transportiert werden und Informationen bzw. Daten von dem Akkumulator 4 zu dem Ladegerät 19 geschickt werden.

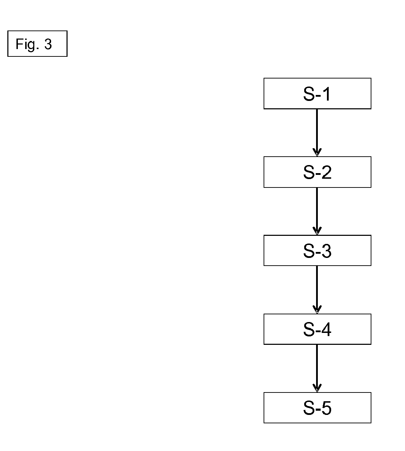

Das erfindungsgemäße Verfahren zum Steuern eines Akkumulators 4 wird nachfolgend anhand der Schritte S-1 bis S-5 der Ablaufdiagramme in den Figuren 3 bis 6 dargestellt und beschrieben.

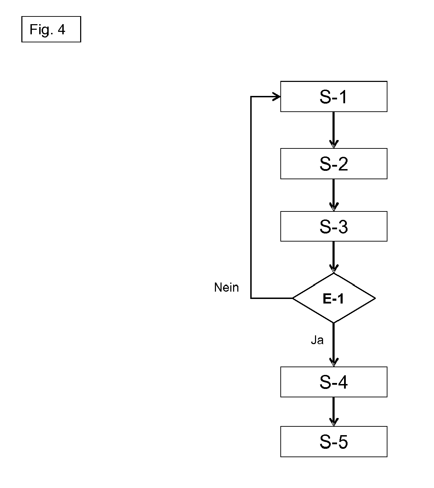

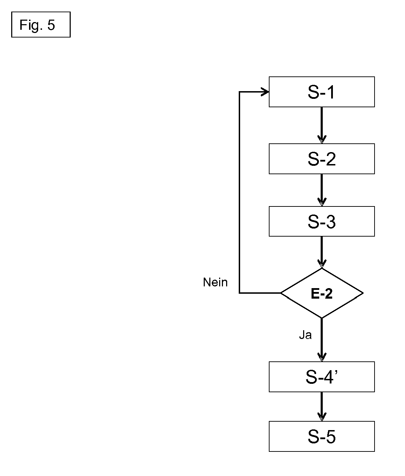

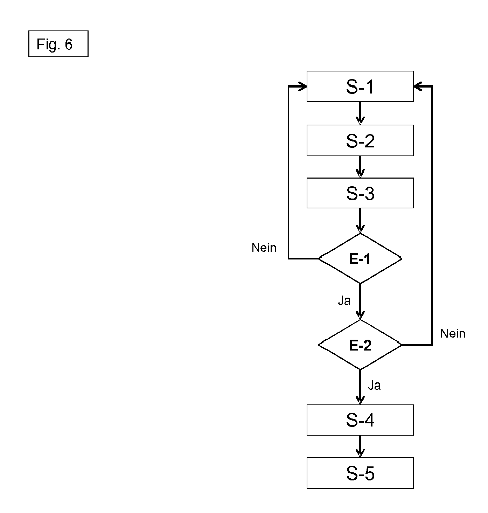

Fig. 3 zeigt dabei eine erste Ausführungsform des erfinderischen Verfahrens, Fig. 4 zeigt dabei eine zweite Ausführungsform des erfinderischen Verfahrens, Fig. 5 zeigt dabei eine dritte Ausführungsform des erfinderischen Verfahrens und Fig. 6 zeigt dabei eine vierte Ausführungsform des erfinderischen Verfahrens.

In dem Schritt S-1 (vgl. Fig. 3) ist der Akkumulator 4 mit dem Ladegerät 19 so verbunden, dass Informationen und elektrische Energie (elektrische Spannung) über die Schnittstellen 23, 16 ausgetauscht werden (vgl. vorstehende Beschreibung zu Fig. 2). Der Akkumulator 4 wird über das Ladegerät 19 elektrisch aufgeladen bis ein erster Ladezustand erreicht ist. Dieser erste Ladezustand kann beispielsweise 90% der elektrischen Kapazität des Akkumulators 4 entsprechen. Der erste Ladezustand wird auf der Speichereinheit der Akku-Steuerungseinrichtung 14 des Akkumulators 4 gespeichert. Es ist jedoch auch möglich, dass der erste Ladezustand des Akkumulators 4 einem höheren oder niedrigeren Wert entspricht. Der erste Ladezustand ist generell der Wert für die elektrische Kapazität, die der Akkumulator 4 nach einem Ladevorgang (d.h. Aufladen des Akkumulators 4 an dem Ladegerät 19) besitzt. Hierbei ist es nicht erforderlich, dass die elektrische Kapazität des Akkumulators 4 nach dem Ladevorgang 100% beträgt; dies kann jedoch der Fall sein.

In dem Schritt S-2 (vgl. Fig. 3) ist der Akkumulator 4, wie in der vorstehend beschriebenen Art, mit der Werkzeugmaschine 1 verbunden (vgl. Fig. 1). Hierbei wird der Werkzeugmaschine 1 die in dem Akkumulator 4 gespeicherte elektrische Kapazität zur Verfügung gestellt, um den Elektromotor 7 zu betreiben. Bei der Inanspruchnahme des Akkumulators 4 durch die Werkzeugmaschine 1 wird die auf dem Akkumulator 4 gespeicherte elektrische Kapazität kontinuierlich reduziert. Mit anderen Worten: der erste Ladezustand des Akkumulators 4 mit einer anfänglichen elektrischen Kapazität von 90% reduziert sich zu einem zweiten Ladezustand mit einer elektrischen Kapazität von beispielsweise lediglich 30%. Die Differenz zwischen dem ersten Ladezustand und dem zweiten Ladezustand beträgt damit 60% (90% - 30% = 60%) der elektrischen Kapazität. Der zweite Ladezustand wird auf der Speichereinheit der Akku-Steuerungseinrichtung 14 des Akkumulators 4 gespeichert. Es ist jedoch auch möglich, dass der zweite Ladezustand einen höheren oder niedrigeren Wert für die elektrische Kapazität aufweist. Der Wert der elektrischen Kapazität für den zweiten Ladezustand richtet sich danach, wie viel der anfänglich auf dem Akkumulator 4 gespeicherten elektrischen Kapazität (erster Ladezustand) ein Anwender zum Betreiben der Werkzeugmaschine 1 verwendet.

In dem dritten Schritt S-3 (vgl. Fig. 3) wird die vorstehend beschriebene Differenz zwischen dem ersten Ladezustand und dem zweiten Ladezustand in Form eines Differenzwertes (90% - 30% = 60% der elektrischen Kapazität des Akkumulators 4) auf der Speichereinheit der Akku-Steuerungseinrichtung 14 des Akkumulators 4 gespeichert. Es ist auch möglich, dass diesem Differenzwert ein Toleranzwert von z.B. +/- 5% zugerechnet wird. Der Toleranzwert kann auch höher oder niedriger sein.

In dem vierten Schritt S-4 (vgl. Fig. 3) wird ein dritter Ladezustand für den Akkumulator 4 festgelegt. Der dritte Ladezustand entspricht dem zuvor ermittelten Differenzwert zwischen ersten Ladevorgang sowie zweiten Ladevorgang (90% - 30% = 60%) und ist der maximal zulässigen Wert für die elektrische Kapazität bei einem nächsten Ladevorgang für den Akkumulator 4. Mit anderen Worten: der Akkumulator 4 kann in einem nächsten Ladevorgang an dem Ladegerät 19 nicht mehr bis zum Erreichen des ersten Ladezustands (d.h. 90% der elektrischen Kapazität) oder der maximalen Kapazität (= 100%), sondern nur noch bis zum Erreichen des dritten Ladezustands (d.h. 60% der elektrischen Kapazität) geladen werden.

In dem fünften Schritt S-5 (vgl. Fig. 3) wird der Akkumulator 4 bis zum Erreichen des dritten Ladezustands (60% der elektrischen Kapazität des Akkumulators 4) geladen. Der Akkumulator 4 ist hierzu mit dem Ladegerät 19 verbunden (vgl. Fig. 2).

Durch das Festlegen eines dritten Ladezustands (60%), der als maximale Obergrenze für einen nachfolgenden Ladevorgang gilt und der unterhalb der maximalen Ladungskapazität des Akkumulators 4 (100%) liegt, kann der Akkumulator 4 vor einer vorzeitigen Alterung sowie Beschädigung durch ein wiederholtes Laden bis zum Erreichen einer maximalen Ladung bewahrt werden, da der Akkumulator nicht mehr zu 100% der elektrischen Kapazität) geladen wird. Da der Anwender für gewöhnlich auch nicht die theoretisch möglichen 100% der elektrischen Kapazität des Akkumulators 4 nutzt, ist dies in der Verwendung des Akkumulators 4 auch nicht problematisch. Wenn sich der Anspruch des Anwenders an die Höhe der zu verwendenden elektrischen Kapazität erhöhen sollte, kann der dritte Ladezustand ebenfalls erhöht und damit eine höhere elektrische Kapazität zur Verfügung gestellt werden.

Gemäß einer zweiten Ausführungsform des erfinderischen Verfahrens ist vorgesehen, dass ein Durchschnittswert von mehreren Ladevorgängen bzw. Ladezyklen (z.B. drei Ladevorgänge bzw. Ladezyklen) zum Festlegen des Differenzwerts zwischen ersten Ladezustand und zweiten Ladezustand zugrunde gelegt wird. Das heißt, es wird eine Historie über eine Anzahl an Verwendungs- und auch Ladungszyklen erstellt. Bei einem Ladezyklus handelt es sich um ein Aufladen sowie um ein Entladen des Akkumulators 4. Für die Festlegung des dritten Ladezustands wird diese Historie berücksichtigt. Hierzu wird für die zweite Ausführungsform des erfinderischen Verfahrens nach Schritt S-3 der Durchschnittswert von drei Ladevorgängen zum Festlegen des Differenzwerts in dem Ereignis E-1 ermittelt (vgl. Fig. 4). In dem Ereignis E-1 wird entschieden, ob bereits drei Ladevorgänge erfolgt sind oder nicht. Wenn drei Ladevorgänge erfolgt sind, setzt sich das Verfahren mit dem Schritt S-4 fort. Wenn noch keine drei Ladevorgänge erfolgt sind, setzt sich das Verfahren mit dem Schritt S-1 fort. Gemäß einer weiteren Ausführungsform des erfinderischen Verfahrens können auch mehr oder weniger Ladevorgänge zu Grunde gelegt werden. Mit Hilfe des ermittelten Durchschnittswerts für den Differenzwert kann die Menge der elektrischen Kapazität, die von dem (nicht gezeigten) Anwender von dem Akkumulator 4 verwendet wird, besser ermittelt werden und ein ständiges Ändern des dritten Ladezustands (d.h. nach jeder Verwendung) vermieden werden.

Gemäß einer dritten Ausführungsform des erfinderischen Verfahrens ist vorgesehen, dass für den dritten Ladezustand ein vorbestimmter (Kapazitäts-)Wert festgelegt wird, wenn der zweite Ladezustand einen vorbestimmten (Kapazitäts-)Wert unterschreitet. Das heißt, wenn der Akkumulator 4 soweit entladen wird, dass der zweite Ladezustand nur noch beispielsweise 20% der elektrischen Kapazität entspricht, wird der dritte Ladezustand auf beispielsweise 95% der elektrischen Kapazität festgelegt. Hierzu wird in dem Ereignis E-2, der dem Schritt S-3 folgt, ermittelt, ob der vorbestimmte (Kapazitäts-)Wert für den zweiten Ladezustand unterschritten wurde (vgl. Fig. 5). Wenn dieser vorbestimmte (Kapazitäts-)Wert unterschritten wurde, wird das Verfahren mit dem Schritt S-4' fortgesetzt und ein vorbestimmter (Kapazitäts-)Wert wird für den dritten Ladezustand festgelegt. Wenn jedoch dieser vorbestimmte (Kapazitäts-)Wert nicht unterschritten wurde, setzt sich das Verfahren mit dem Schritt S-1 fort.

Gemäß einer vierten Ausführungsform des erfinderischen Verfahrens ist vorgesehen, dass nach dem Schritt S-3 die vorstehend beschriebenen Ereignisse E-1 und E-2 nachfolgend durchgeführt werden (vgl. Fig. 6).

## Patentansprüche

1. Verfahren zum Steuern eines Akkumulators (4), wobei der Akkumulator (4) eine Akku-Steuerungseinrichtung (14) enthält und beispielsweise zur Versorgung einer Werkzeugmaschine (1) mit elektrischer Energie verwendbar ist,
**gekennzeichnet durch** die Schritte:
- Ermitteln eines Differenzwertes zwischen einem ersten Ladezustand des Akkumulators (4) und einem zweiten Ladezustand des Akkumulators (4), wobei der erste Ladezustand einem Ladezustand des Akkumulators (4) nach Beendigung eines Ladevorgangs entspricht und der zweite Ladezustand einen geringeren Ladezustandswert als der erste Ladezustand aufweist;
- Festlegen eines dritten Ladezustands, der dem Differenzwert entspricht, wobei der dritte Ladezustand einem Ladezustandswert entspricht, der geringer als ein maximaler Ladezustandswert des Akkumulators (4) ist; und
- Laden des Akkumulators (4) bis zum Erreichen des dritten Ladezustands.

2. Verfahren nach Anspruch 1,
**dadurch gekennzeichnet, dass** das Festlegen des dritten Ladezustands nach einer vorbestimmten Anzahl an Ladevorgängen des Akkumulators (4) erfolgt, wobei der Ladezustandswert des dritten Ladezustands einem durchschnittlichen Differenzwert entspricht.

3. Verfahren nach Anspruch 1 oder 2,
**dadurch gekennzeichnet, dass** das Festlegen des dritten Ladezustands auf einen vorbestimmten ersten Schwellwert erfolgt, wenn der zweite Ladezustand einen vorbestimmten zweiten Schwellwert unterschreitet.

4. Verfahren nach wenigstens einem der Ansprüche 1 bis 3,
**dadurch gekennzeichnet, dass** das Festlegen des dritten Ladezustands mittels einer an dem Akkumulator (4) positionierten Eingabevorrichtung erfolgt.

5. Verfahren nach wenigstens einem der Ansprüche 1 bis 4,
**dadurch gekennzeichnet, dass** der erste, zweite und dritte Ladezustand einer Kapazität, einer Ladespannung oder einem Ladestrom entspricht.

6. Akkumulator (4) zur Durchführung des Verfahrens nach wenigstens einem der Ansprüche 1 bis 5.
